# EUROPÄISCHE PATENTSCHRIFT

(11) **EP 0 463 332 B1**
(45) Veröffentlichungstag und Bekanntmachung des Hinweises auf die Patenterteilung: **15.11.1995**
(21) Anmeldenummer: 91107433.4
(22) Anmeldetag: 07.05.1991
(51) Int. Cl.: H01L 29/49, H01L 21/28

(54) **Verfahren zur Herstellung einer dotiertes Polysilizium und Metallsilizid enthaltenden Mehrschichtgateelektrode für einen MOS-Transistor**
Manufacturing method of a multilayer gate electrode containing doped polysilicon and metal-silicide for a MOS-transistor
Méthode de fabrication d'une électrode de grille multicouche contenant du polysilicium dopé et du siliciure métallique pour un transistor MOS

(30) Priorität: 19.06.1990 DE 4019538
(43) Veröffentlichungstag der Anmeldung: 02.01.1992
(73) Patentinhaber: SIEMENS AKTIENGESELLSCHAFT, 80333 München (DE)
(72) Erfinder: Schwalke, Udo, Dr., Willston, VT 05495 (US); Joswig, Hellmut, Dr., W-8000 München 90 (US)

(56) Entgegenhaltungen:
- EP-A- 0 284 794
- EP-A- 0 295 367
- IBM TECHNICAL DISCLOSURE BULLETIN. Bd. 27, Nr. 11, April 1985, NEW YORK US Seiten 6652 - 6655; 'THREE DUAL POLYSILICON GATE CMOS WITH DIFFUSION BARRIERS AND THE PROCESS FOR FORMING EACH"
- PATENT ABSTRACTS OF JAPAN vol. 011, no. 320 (E-550)17. Oktober 1987 & JP- A-62 111 466
- PATENT ABSTRACTS OF JAPAN vol. 009, no. 251 (E-348)8. Oktober 1985 & JP-A-60 100 464

## Beschreibung

Die Erfindung betrifft ein Verfahren zur Herstellung einer dotiertes Polysilizium und Metallsilizid enthaltenden Mehrschichtgateelektrode für einen MOS-Transistor.

In der CMOS-Technologie gewinnt die gleichzeitige Silizidierung von Gate- und Source/Drain-Gebieten zunehmend an Bedeutung. Die dabei erzielte Reduzierung der Schicht- und Kontaktwiderstände der Gateelektrode sowie der Source/Drain-Anschlüsse trägt zur Verbesserung der Transistor-Performance bei. Dieses Verfahren, das SALICIDE (self aligned silicide) Prozeß genannt wird, ist z. B. aus M.E. Alperin et al., IEEE Trans. Electron Devices, ED-32, 141 (1985) bekannt. Dabei wird ein Metall, z. B. Titan, ganzflächig auf die Oberfläche der Source- bzw. Drain-Gebiete sowie auf eine dotierte Polysiliziumstruktur, die oberhalb des Gateoxids angeordnet ist und die Teil der Gateelektrode bildet, abgeschieden. Bei einer gezielten Temperung tritt auf den freiliegenden Siliziumflächen, d. h. auf der dotierten Polysiliziumstruktur sowie der Oberfläche der Source/Drain-Gebiete, eine Silizidbildung ein. Auf Flächen, die mit Oxid oder Nitrid maskiert sind, bleibt dagegen das unreagierte Metall erhalten. Durch eine Ätze, die das Metall selektiv zum Silizid entfernt, werden das Metall und eventuelle Reaktionsprodukte entfernt. Es bleiben nur die silizidierten Gateelektrode und Source/Drain-Anschlüsse erhalten.

Ein wesentlicher Nachteil dieses Verfahrens ist darin zu sehen, daß während des Temperprozesses eine Dotierstoffabreicherung auftritt. Unter der Dotierstoffabreicherung versteht man einen Rückfluß von Dotierstoff aus den Silizium-Gebieten in das Silizid. Dieser Effekt ist bei der dotierten Polysiliziumstruktur aufgrund der schnellen Korngrenzendiffusion besonders ausgeprägt.

Der Grund für die Dotierstoffabreicherung ist darin zu sehen, daß gleichzeitig mit der Silizidbildung eine parasitäre Metall-Dotierstoffreaktion stattfindet. Bei dieser Metall-Dotierstoffreaktion werden stabile Metall-Dotierstoffverbindungen, z. B. TiB₂ gebildet.

Fällt die Dotierstoffkonzentration in der dotierten Polysiliziumstruktur, die Teil der Gateelektrode bildet, unter etwa 5 x 10¹⁹ cm⁻³, d. h. enthält die dotierte Polysiliziumstruktur nicht mehr degeneriert dotiertes Polysilizium, so bildet sich eine Raumladungszone in der Gateelektrode aus. Dieser mit Gate-Depletion bezeichnete Effekt ist z. B. aus C.Y. Wong et al. Techn. Dig. IEDM 88, pp. 238-241 (1988) bekannt.

Aus R.A. Chapman et al. Techn. Dig. IEDM 88, pp. 52-55 (1988) ist bekannt, daß die Dotierstoffabreicherung in der dotierten Polysiliziumstruktur eine Verringerung des Sättigungsdrainstroms bewirkt. Sie verschlechtert auch das Unterschwellenverhalten.

Weiterhin führt die Dotierstoffabreicherung zu Änderungen in der Austrittsarbeit und somit zu Einsatzspannungsverschiebungen.

Aus H. Hayashida et al. Conf. Proc. VLSI Symp., pp. 29-30 (1989) und B. Davari et al. Techn. Dig. IEDM 88, p. 56-59 (1988) sind Maßnahmen bekannt, mit denen versucht wird, die Dotierstoffabreicherung zu unterbinden.

Aus H. Hayashida et al. Conf. Proc. VLSI Symp., pp. 29-30 (1989) ist bekannt, durch eine Beschränkung des Temperaturbudget die Dotierstoffabreicherung zu beeinflussen. Die Verringerung des Temperaturbudget bedeutet jedoch eine wesentliche Einschränkung in der Prozeßführung. Mit dieser Maßnahme sind nur geringe Verbesserungen bezüglich der Dotierstoffabreicherung erzielbar, so daß die damit verbundene Einschränkung der Prozeßführung nicht vertretbar erscheint.

Aus B. Davari et al. Techn. Dig. IEDM 88, pp. 56-59 (1988) ist bekannt, die Dotierstoffabreicherung durch eine Verringerung der Siliziddicke zu beeinflussen. Eine Verringerung der Siliziddicke führt jedoch zu einer Verringerung der Leitfähigkeit der Gateelektrode. Darüberhinaus verschlechtert sich dadurch die Temperaturbeständigkeit des Silizids (s. R. Burmester et al., Conf. Proc. ESSDERC 89, pp. 233-236 (Springer Verlag. 1989, Eds.: Heuberger, Ryssel, Lange)).

Eine derartige Mehrschichtgateelektrode ist ebenfalls aus IBM Technical Disclosure Bulletin, Vol. 27, pp. 6652-6655 (1985) für ein Dual gate CMOS-Prozeß bekannt. In dieser Veröffentlichung wird jedoch die Aufgabe gelöst, die Diffusion von p-dotierenden Dotierstoffen durch die Silizidschicht in n-dotierte Teile der dotierten Polysiliziumschicht und umgekehrt zu verhindern. Dieses Problem tritt aber in einem SALICIDE-Prozeß nicht auf, da hier keine durchgehende Silizidschicht vorhanden ist.

Der Erfindung liegt daher die Aufgabe zugrunde, ein Verfahren zur Silizidierung einer dotiertes Polysilizium enthaltenden Gateelektrode anzugeben, bei dem die Dotierstoffabreicherung des Polysiliziums vermieden wird und welches gleichzeitig mit einem SALICIDE-Prozeß kompatibel ist.

Diese Aufgabe wird erfindungsgemäß gelöst durch ein Verfahren zur Herstellung einer dotiertes Polysilizium und Metallsilizid enthaltenden Mehrschichtgateelektrode für einen MOS-Transistor gemäß dem Anspruch 1.

In dem erfindungsgemäßen Verfahren wird die Metallsilizidstruktur aus der Siliziumstruktur und der darüber angeordneten Metallschicht gebildet. Die dotierte Polysiliziumstruktur ist von der Metallschicht durch die Diffusionsbarrierestruktur und die Siliziumstruktur getrennt. Da die Diffusion von Dotierstoff aus der Polysiliziumstruktur in Richtung Metallschicht durch die Diffusionsbarrierestruktur verhindert wird, kann es zu einer Metall-Dotierstoffreaktion, die eine Dotierstoffabreicherung verursachen würde, bei dem Temperprozeß nicht kommen.

Für die Diffusionsbarrierestruktur ist insbesondere TiN geeignet. TiN weist neben guter elektrischer Leitfähigkeit und thermischer Stabiliät auch in oxidierender Atmosphäre bis etwa 950 °C eine ausreichend gute Barrierewirkung auf. Durch eine Temperaturbehandlung bei z. B. 500°C - 700°C oder z. B. in einem RTA (=rapid thermal anneal)-Schritt nach dem Abscheiden des TiN wird die Barrierewirkung des TiN weiter verbessert. Bei Verwendung von TiN als Diffusionsbarrierestruktur sind aufgrund der guten Temperaturfestigkeit des Materials konventionelle Reoxidationen, Spacertechnologien und Source/Drain-Temperungen möglich.

Das erfindungsgemäße Herstellverfahren ist mit einem herkömmlichen SALICIDE-Prozeß kompatibel. Die Metallschicht wird in einem SALICIDE-Prozeß so aufgebracht, daß sie gleichzeitig die Mehrschichtstruktur und vorgegebene Orte auf dem Substrat für einen Sourceanschluß und einen Drainanschluß bedeckt. Source- und Drain-Gebiet werden zuvor durch Implantation oder Diffusion unter Verwendung einer fremdjustierten oder selbstjustierten Maske erzeugt. Als selbstjustierte Maske ist die Mehrschichtstruktur geeignet. In dem Temperschritt bilden sich dann die Source- und Drain-Anschlüsse aus der Metallschicht mit der damit in Kontakt stehenden Siliziumoberfläche des Source- bzw. Drain-Gebietes.

Weitere Ausgestaltungen der Erfindung gehen aus den übrigen Ansprüchen hervor.

Die Verwendung einer Mehrschichtgateelektrode bestehend aus einer Polysiliziumschicht, einer Titannitridschicht und einer Metallsilizidschicht eines hochschmelzenden Metalles für einen MOS-Transistor ist zwar aus Patent abstracts of Japan, Bd. 11, Nr. 320 (E-550) (2767), 17.10.1987, JP-A-62-111466 bekannt. In dieser Veröffentlichung wird jedoch die Aufgabe gelöst, eine Zerstörung des Gateoxids durch Diffusion von Titan in das Gateoxid zu verhindern. Desweiteren ist der MOS-Transistor nicht in einem SALICIDE-Prozeß hergestellt.

Im folgenden wird die Erfindung anhand eines Ausführungsbeispiels und der Figuren näher erläutert.

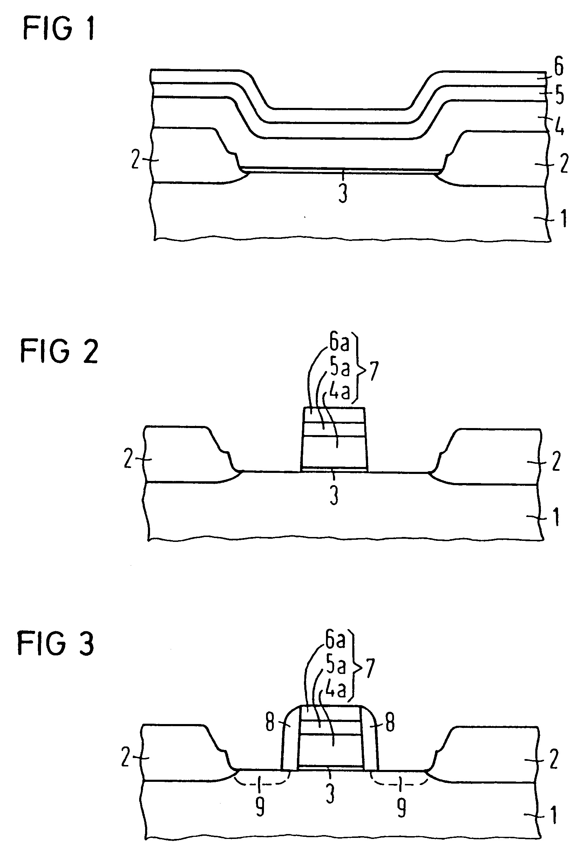

Fig. 1 bis Fig. 6 zeigen Schritte eines SALICIDE-Prozesses mit einer Mehrschichtgatelektrode zur Unterdrückung der Dotierstoffabreicherung.

Auf einem Substrat 1 aus z. B. Silizium mit Feldoxidbereichen 2 zur Trennung aktiver Bereiche im Substrat 1 und einer Gateoxidschicht 3 wird ganzflächig eine dotierte Polysiliziumschicht 4 abgeschieden (s. Fig. 1). Die dotierte Polysiliziumschicht 4 wird z. B. in einer Dicke von 300 nm und mit einer Dotierung von 1 x 10²⁰ B/cm³ erzeugt. Auf der dotierten Polysiliziumschicht 4 wird ganzflächig eine Diffusionsbarriereschicht 5 erzeugt. Die Diffusionsbarriereschicht 5 besteht z. B. aus TiN und weist eine Dicke von z. B. 10-40 nm auf. Auf der Diffusionsbarriereschicht 5 wird eine Silizium-Deckschicht 6 erzeugt. Die Silizium-Deckschicht besteht entweder aus amorphem oder aus polykristallinem Silizium. Sie weist eine Dicke von etwa 80-100 nm auf.

In einem Trockenätzprozeß werden die Silizium-Deckschicht 6, die Diffusionsbarriereschicht 5, die dotierte Polysiliziumschicht 4 und die Gateoxidschicht 3 strukturiert (s. Fig. 2). Dabei entstehen aus der dotierten Polysiliziumschicht 4 eine dotierte Polysiliziumstruktur 4a, aus der Diffusionsbarriereschicht 5 eine Diffusionsbarrierestruktur 5a und aus der Siliziumdeckschicht 6 eine Siliziumstruktur 6a, die gemeinsam eine Mehrschichtstruktur 7 bilden.

An den Flanken der Mehrschichtstruktur 7 werden Flankenbedeckungen 8, sogenannte Spacer, erzeugt (s. Fig. 3). Die Flankenbedeckungen 8 bestehen z. B. aus SiO₂ und werden durch konforme Abscheidung einer SiO₂-Schicht und anschließendes, anisotropes Rückätzen der SiO₂-Schicht erzeugt (nicht im einzelnen dargestellt).

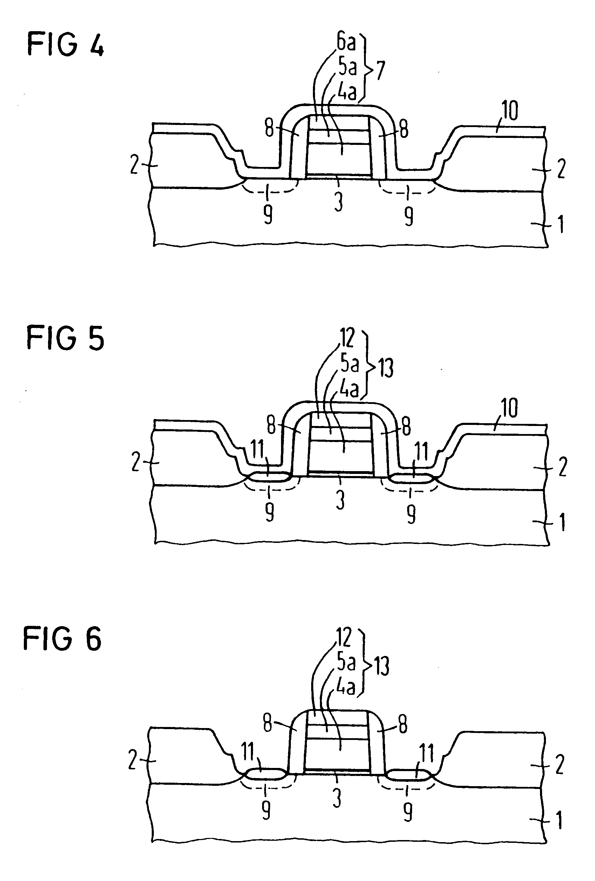

Unter Verwendung der mit den Flankenbedeckungen 8 versehenen Mehrschichtstruktur 7 und der angrenzenden Feldoxidbereiche 2 als selbstjustierter Maske werden Source- und Drain-Gebiete 9 durch Implantation von z. B. Arsen oder Bor im Substrat 1 erzeugt. Auf die Oberfläche der Feldoxidbereiche 2, der Source- und Drain-Gebiete 9, der Flankenbedeckungen 8 und der Siliziumstruktur 6a wird ganzflächig einer Metallschicht 10 aufgebracht (s. Fig. 4). Die Metallschicht 10 besteht z. B. aus Ti und weist eine Dicke von z. B. 40-60 nm auf.

In einem Temperschritt bei z. B. 700 °C findet eine selektive Silizidbildung an den Grenzflächen der Metallschicht 10 mit Silizium statt (s. Fig. 5). Diese Grenzflächen befinden sich im Bereich der Source- und Drain-Gebiete 9 sowie der Siliziumstruktur 6a. Um eine vollständige Silizidierung der Siliziumstruktur 6a bis zur Diffusionsbarrierestruktur 5a zu gewährleisten, muß die Metallschicht 10 so dick sein, daß ein ausreichender Metallüberschuß gegeben ist. Bei einer Dicke der Siliziumstruktur 6a von z. B. 80 nm muß die Metallschicht 10 aus z. B. Ti mindestens eine Dicke von 40 nm aufweisen. An der Oberfläche der Source- und Drain-Gebiete 9 werden in diesem Schritt Source- und Drain-Anschlüsse 11 aus Metallsilizid gebildet. Die Siliziumstruktur 6a wird durch die Silizidierung in eine Metallsilizidstruktur 12 verwandelt. Die Metallsilizidstruktur 12 bildet zusammen mit der Diffusionsbarrierestruktur 5a und der dotierten Polysiliziumstruktur 4a eine Mehrschichtgatelektrode 13.

In einem Ätzprozeß mit z. B. in NH₄OH/H₂O₂/H₂O wird abschließend nicht reagiertes Metall der Metallschicht 10 und eventuelle Reaktionsprodukte selektiv zu der Metallsilizidstruktur 12 und den Source- und Drain-Anschlüssen 11 entfernt. In einem weiteren Temperaturschritt wird das Metallsilizid der Metallsilizidstruktur 12 und der Source- und Drain-Anschlüsse 11 in eine stabile Phase überführt. Es ergibt sich die in Fig. 6 dargestellte Struktur.

Mit Hilfe von Messungen konnte die Wirksamkeit einer Diffusionsbarrierestruktur aus TiN hinsichtlich Dotierstoffabreicherung von Bor gezeigt werden: Unter Verwendung einer Diffusionsbarrierestruktur aus TiN wurde eine um ca. eine Größenordnung (d. h. um den Faktor 10) höhere Bor-Konzentration in der dotierten Polysiliziumstruktur nach einer Temperung bei 900 °C, 5 Min. in N₂ erreicht als in einer vergleichbaren dotierten Polysiliziumstruktur ohne Diffusionsbarrierestruktur.

## Patentansprüche

1. Verfahren zur Herstellung eines MOS-Transistors mit einer dotiertes Polysilizium und Metallsilizid enthaltenden Mehrschichtgateelektrode mit folgenden Schritten:
a) auf einem Substrat (1) wird eine Gateoxidschicht (3) erzeugt,
b) auf die Gateoxidschicht (3) wird eine dotierte Polysiliziumschicht (4) aufgebracht ,
c) auf die dotierte Polysiliziumschicht (4) wird eine Diffusionsbarriereschicht (5) aufgebracht,
d) auf die Diffusionsbarriereschicht (5) wird eine Siliziumdeckschicht (6) abgeschieden,
e) nach einer Phototechnik wird durch anisotropes Rückätzen der Siliziumdeckschicht (6), der Diffusionsbarriereschicht (5) und der dotierten Polysiliziumschicht (4) an einem für die Mehrschichtgateelektrode (13) vorgegebenen Ort eine Mehrschichtstruktur (7) erzeugt, die auf dem Substrat (1) eine dotierte Polysiliziumstruktur (4a), darauf eine Diffusionsbarrierestruktur (5a) und darauf eine Siliziumstruktur (6a) enthält,
f) an den Flanken der Mehrschichtstruktur (7) werden Flankenbedeckungen (8) erzeugt,
g) durch eine Ionenimplantation, bei der die Mehrschichtstruktur (7) als Implantationsmaske wirkt, werden im Substrat (1) ein Sourcegebiet (9) und ein Draingebiet (9) erzeugt,
h) auf das Substrat (1) wird eine Metallschicht (10) aufgebracht, die die Mehrschichtstruktur (7) und die Oberflächen von Source- und Draingebiet (9) bedeckt,
i) es wird eine Temperaturbehandlung durchgeführt, bei der aus der Metallschicht (10) und der Siliziumstruktur (6a) eine Metallsilizidstruktur (12) erzeugt wird und bei der aus der Metallschicht (10) und der Oberfläche des Sourcegebietes (9) bzw. Draingebietes (9) jeweils ein Sourceanschluß (11) bzw. Drainanschluß (11) aus Metallsilizid gebildet wird,
j) die Diffusionsbarriereschicht (5) wird aus einem Material erzeugt, das eine Diffusion von Dotierstoff aus der Polysiliziumstruktur (4a) in die Metallsilizidstruktur (12) verhindert.

2. Verfahren nach Anspruch 1,
**dadurch gekennzeichnet**,
daß die Diffusionsbarriereschicht (5) aus TiN erzeugt wird.

3. Verfahren nach Anspruch 2,
**dadurch gekennzeichnet,**
daß die Diffusionsbarriereschicht (5) vor dem Abscheiden der Siliziumdeckschicht (6) einer Temperaturbehandlung unterzogen wird.

4. Verfahren nach einem der Ansprüche 1 bis 3,
**dadurch gekennzeichnet,**
daß zur Herstellung der Flankenbedeckungen (8) eine ganzflächige, gleichförmige Isolationsschicht erzeugt wird, aus der durch anschließendes anisotropes Rückätzen die Flankenbedeckungen (8) gebildet werden.

## Claims

1. Method of producing an MOS transistor having a multilayer gate electrode containing doped polysilicon and metal suicide by means of the following steps:
a) a gate oxide layer (3) is produced on a substrate (1),
b) a doped polysilicon layer (4) is applied to the gate oxide layer (3),
c) a diffusion barrier layer (5) is applied to the doped polysilicon layer (4),
d) a silicon top layer (6) is deposited on the diffusion barrier layer (5),
e) after a photolithographic procedure, a multilayer structure (7) which contains, on the substrate (1) a doped polysilicon structure (4a), a diffusion barrier structure (5a) on top of the latter and a silicon structure (6a) on top thereof, is produced at a position specified for the multilayer gate electrode (13) by anisotropic back-etching of the silicon top layer (6), the diffusion barrier layer (5) and the doped polysilicon layer (4),
f) edge coverings (8) are produced at the edges of the multilayer structure (7),
g) a source zone (9) and a drain zone (9) are produced in the substrate (1) by an ion implantation in which the multilayer structure (7) acts as implantation mask,
h) a metal layer (10) which covers the multilayer structure (7) and the surfaces of source zone and drain zone (9) is applied to the substrate (1),
i) a temperature treatment is carried out in which a metal silicide structure (12) is produced from the metal layer (10) and the silicon structure (6a) and in which a metal silicide source connection (11) or drain connection (11) is formed in each case from the metal layer (10) and the surface of the source zone (9) or drain zone (9), respectively,
j) the diffusion barrier layer (5) is produced from a material which prevents a diffusion of dopant into the metal silicide structure (12) from the polysilicon structure (4a).

2. Method according to Claim 1, characterized in that the diffusion barrier layer (5) is produced from TiN.

3. Method according to Claim 2, characterized in that the diffusion barrier layer (5) is subjected to a temperature treatment before the deposition of the silicon top layer (6).

4. Method according to one of Claims 1 to 3, characterized in that, to produce the edge coverings (8), a surface-wide uniform insulation layer is produced from which the edge coverings (8) are formed by subsequent anisotropic back-etching.

## Revendications

1. Méthode de fabrication d'un transistor MOS avec une électrode de grille multicouche contenant du polysilicium dopé et du siliciure métallique, comportant les étapes suivantes:
a) on produit sur un substrat (1) une couche d'oxyde de grille (3);
b) on applique sur la couche d'oxyde de grille (3) une couche de polysilicium dopée (4);
c) on applique sur la couche de polysilicium dopée (4) une barrière anti-diffusion (5);
d) on précipite sur la barrière anti-diffusion (5) une couche de recouvrement de silicium (6);
e) selon une phototechnique, on produit par attaque en retrait anisotrope de la couche de recouvrement de silicium (6), de la barrière anti-diffusion (5) et de la couche de polysilicium dopée (4), à un endroit prédéfini pour l'électrode de grille multicouche (13), une structure multicouche (7) comportant sur le substrat (1) une structure de polysilicium dopée (4a), là-dessus une structure de barrière anti-diffusion (5a) et là-dessus une structure de silicium (6a);
f) on réalise aux flancs de la structure multicouche (7) des recouvrements de flanc (8);
g) on réalise par une implantation d'ions où la structure multicouche agit comme masque d'implantation, dans le substrat (1) une région de source (9) et une région de drain (9);
h) on applique sur le substrat (1) une couche métallique (10) qui recouvre la structure multicouche (7) et les surfaces de la région de source et de drain (9);
i) on effectue un traitement thermique, lors duquel on obtient à partir de la couche métallique (10) et de la structure de silicium (6a) une structure de siliciure métallique (12), et lors duquel se forme à partir de la couche métallique (10) et de la surface de la région de source (9) ou de la région de drain (9) respectivement une borne de source (11) ou une borne de drain (11) en siliciure métallique;
j) on réalise la barrière anti-diffusion en un matériau qui empêche une diffusion d'agent de dopage en provenance de la structure de polysilicium (4a) dans la structure de siliciure métallique (12).

2. Méthode selon la revendication 1, caractérisée en ce que la barrière anti-diffusion est réalisée en TiN.

3. Méthode selon la revendication 2, caractérisée en ce que la barrière anti-diffusion (5) est soumise avant la précipitation de la couche de recouvrement de silicium (6) à un traitement thermique.

4. Méthode selon l'une des revendications 1 à 3, caractérisée en ce que l'on réalise pour la fabrication des recouvrements de flanc (8) une couche isolante uniforme couvrant toute la surface, à partir de laquelle on forme par attaque en retrait anisotrope subséquente les recouvrements de flanc (8).
